# EUROPEAN PATENT APPLICATION

(11) **EP 4 685 855 A1**
(43) Date of publication of application: **28.01.2026**
(21) Application number: 22315102.8
(22) Date of filing: 11.05.2022
(51) Int. Cl.: H01L 43/02, H01L 43/08, H01L 43/12, H01F 10/32

(54) **MAGNETIC MEMORY CELL AND SELF-ALIGNED MANUFACTURING METHOD THEREOF**

(71) Applicant: Antaios, 38240 Meylan (FR)
(72) Inventor: Levi, Amitay, CUPERTINO, 95014-1818 (US); Drouard, Marc, 26000 VALENCE (FR); Kumar, Raj, SAN JOSE, 95131 (US)

(57) **Abstract**

A SOT-MRAM cell (700) comprising a magnetic tunnel junction (MTJ) including a SOT layer (SOT); a dielectric layer (Ox) stacked with the magnetic tunnel junction (MTJ) and in direct contact with the SOT layer (SOT) ; an electrically insulating encapsulating layer (Encaps) covering a sidewall of the magnetic tunnel junction (MTJ) ; and an electrically conductive layer (El_{A}) in direct contact with the SOT layer, wherein the dielectric layer (Ox) presents a recess (Rec) formed by a sidewall of the dielectric layer (Ox) being inboard from the sidewall (MTJsw) of the magnetic tunnel junction (MTJ), and the electrically conductive layer (El_{A}) covers the electrically encapsulating layer (Encaps) and is in direct contact with the SOT layer (SOT) via the recess (Rec) of the dielectric layer (Ox) .

## Description

### FIELD OF THE INVENTION

The technical domain of the invention is that of Magnetoresistive Random Access Memory (MRAM) cells, that each comprises a Magnetic Tunnel Junction (MTJ) whose magnetic state defines a bit of information.

### BACKGROUND OF THE INVENTION

An MTJ comprises a stack of two ferromagnetic layers separated by an electrically insulating tunnel layer that is thin enough to allow electrons to pass from one of the ferromagnetic layer to the second one by quantum tunneling.

The resistance of the MTJ to electrical current passage is governed by quantum mechanical physics and more specifically by Tunnel Magnetoresistance (TMR).

One of the two ferromagnetic layers has a pinned (or fixed) magnetization while the other one has a magnetization that can be modified, and they are therefore often referred to as the pinned ferromagnetic layer (or fixed ferromagnetic layer, or also reference ferromagnetic layer) and the free ferromagnetic layer, respectively.

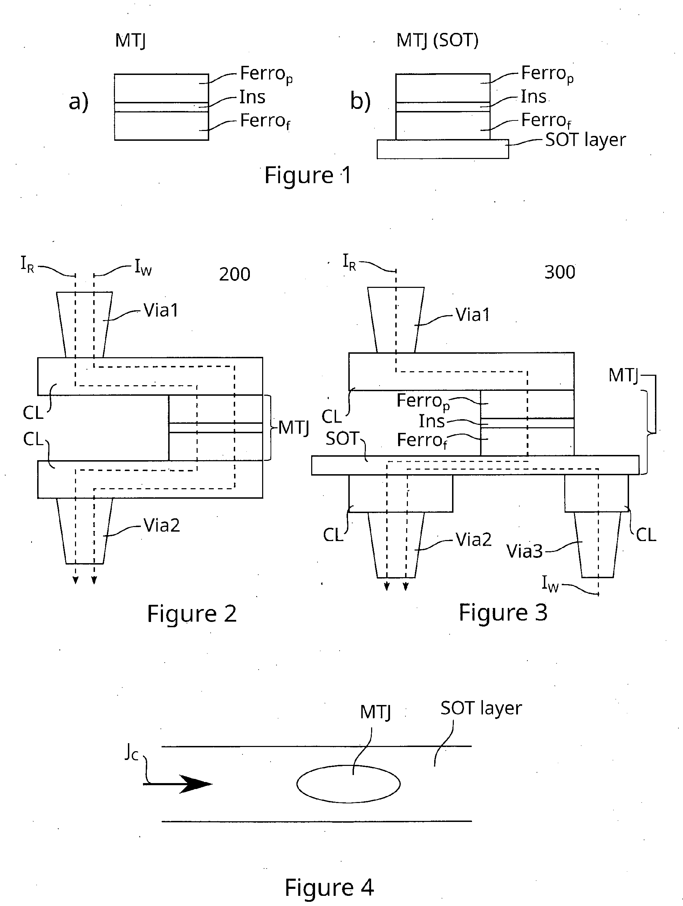

Fig.1 illustrates at a) such an MTJ, with a pinned ferromagnetic layer Ferroₚ and a free ferromagnetic layer Ferro_{f} with an insulating layer Ins therebetween.

In an actual device, an MTJ comprises other layers in addition to those cited so far, used to improve control over the states of the MTJ and/or inject currents therein and/or that are necessary for its manufacturing process.

A prominent example of such additional layer would be a synthetic antiferromagnetic structure pinning the magnetization of the pinned layer ferroₚ.

An MTJ exhibits two states: a low-resistance state in which magnetizations of the two ferromagnetic layers are in a parallel state, i.e. magnetizations of both ferromagnetic layers are oriented towards a same direction, and a high-resistance state in which magnetizations of the two ferromagnetic layers are in an antiparallel state, i.e. magnetizations of the two ferromagnetic layers are oriented towards two opposite directions.

Each memory cell of an MRAM comprises an MTJ in which these two states and their corresponding electrical resistance values are associated to bit values, "0" or "1", that are read by circulating an electrical current through the MTJ to determine its electrical resistance value.

The fixed ferromagnetic layer is used as a reference ferromagnetic layer and the free ferromagnetic layer can be written (i.e. its magnetization orientation can be controlled) at will by application of a current or a magnetic field.

Regarding the writing mechanism, one may cite three types of MRAM: Field switching MRAM, Spin Transfer Torque MRAM (STT-MRAM) and Spin Orbit Torque MRAM (SOT-MRAM), that differ in their mechanisms for writing the free ferromagnetic layer.

An STT-MRAM cell is written by circulating a current along the same path as the current used for the reading operation, perpendicularly to the junction, through the insulator Ins of the MTJ.

These operational characteristics materialize in that an STT-MRAM cell possesses 2 terminals used to circulate both of the writing current Iw and the reading current I_{R}, often corresponding , to two respective vias Via1 and Via2 and corresponding electrically conductive lines CL for electrical connections with the circuitry of the memory, as in the STT-MRAM 200 illustrated by Fig. 2.

In contrast, a SOT-MRAM cell is written by circulating a current adjacent to the free ferromagnetic layer, in parallel to the junction, the current circulating on a given side of the insulator of the MTJ.

In consequence, a SOT-MRAM cell possesses 3 terminals: typically, a first and a second one are used for circulating the writing current Iw in the SOT line while the reading current I_{R} passes through the third one and at least one of the first and the second ones, these three terminals often corresponding to three respective vias Vial, Via2 and Via3 and associated respective electrically conductive lines CL for electrical connections with the circuitry of the memory, as in the SOT-MRAM 300 illustrated by Fig. 3.

Further, the MTJ of a SOT-MRAM cell comprises a spin-orbit interaction active layer, or SOT layer, in direct contact with the free ferromagnetic layer Ferro_{f} of the MTJ as illustrated in Fig. 1 at b) and in Fig. 3, and serves to facilitate switching of the magnetization orientation of the free ferromagnetic layer upon circulation of the writing current Iw in the SOT layer during a write operation of the SOT-MRAM cell.

The SOT layer, indicated by reference SOT, is connected at two of its opposite extremities to respective electrically conductive lines CL, so that the electrical path followed by the writing current Iw flows adjacent to the free ferromagnetic layer Ferro_{f} of the magnetic tunnel junction MTJ.

Extremities of the SOT layer are defined as the portions of the SOT layer adjacent to (more specifically, overlaps vertically with) electrically conductive lines configured to bring the writing current to or from the SOT layer.

Having the writing current Iw passing through the two opposite extremities of the SOT layer allows maximizing the influence of this current onto the free ferromagnetic layer Ferro_{f}.

In addition, a magnetic hard bias layer may optionally be added to the structure of the SOT-MRAM cell structure, that has for function to enhance control over the switching of the MTJ between its two states.

As the magnetic hard bias layer, a layer can be configured to generate a magnetic bias field interacting with the magnetization of the free ferromagnetic layer such that this magnetization is deterministically switchable from a first to a second magnetization state when the writing current is passed, as disclosed for example in the patent publication EP 3 866 168 A1.

The structures above are manufactured using conventional microfabrication processes involving alignment operations that cannot be carried out with an absolute precision, so that the. patterns that are employed to define the different elements of the structure to be made presents some overlay margins, in particular in the SOT-MRAM instance.

As an example of a mitigation measure to make up for such technical limitations in a SOT-MRAM cell, the width of the SOT layer is conventionally larger than the lateral dimensions of the rest of the MJT stack, as illustrated in Fig. 4, which limits the potential miniaturization of such cell.

A consequence of this larger width is that to maintain a given current density Jc, the total current needs to be higher, increasing transistor size in the circuit controlling the MRAM cell and using more power during write operations.

Further, slight differences in alignment in processes requiring alignment operations can result in variations between arrays of MRAM memories.

### OBJECT OF THE INVENTION

The present invention aims at providing devices that do not suffer from the drawbacks explained above

### SUMMARY OF THE INVENTION

To this effect, a first aspect of the invention relates to a SOT-MRAM cell comprising a magnetic tunnel junction including a SOT layer ; a dielectric layer stacked with the magnetic tunnel junction and in direct contact with the SOT layer ; an electrically insulating encapsulating layer covering a sidewall of the magnetic tunnel junction ; and an electrically conductive layer in direct contact with the SOT layer, wherein the dielectric layer presents a recess formed by a sidewall of the dielectric layer being inboard from the sidewall of the magnetic tunnel junction ; and the electrically conductive layer covers the electrically encapsulating layer and is in direct contact with the SOT layer via the recess of the dielectric layer.

A SOT-MRAM cell according to the invention can be easily scaled down and can be obtained by means of a self-aligned process, meaning here that the electrically conductive layer does not require a precise alignment to be adequately positioned with regard to the SOT layer.

Accordingly, such a memory can make use of a given area and input current more efficiently, resulting in lower currents circulating in the memory cells compared to conventional memory cells, a cheaper, less energy consuming, and more reliable SOT-MRAM.

According to further non limitative features of the first aspect of the invention, either taken alone or in any technically feasible combination :
- the electrically conductive layer can be in direct contact with a top surface of the SOT layer;
- the electrically conductive layer can be in direct contact with a bottom surface of the SOT layer;
- the SOT-MRAM cell can comprise an additional electrically conductive layer stacked over the electrically conductive layer;
- the additional electrically conductive layer can comprise a ferromagnetic material;
- the additional electrically conductive layer can have a sidewall facing the sidewall of the magnetic tunnel junction;
- the additional electrically conductive layer can be in direct contact with the electrically conductive layer;
- the magnetic memory cell can comprise a second electrically conductive layer in direct contact with the SOT layer via a second recess of the dielectric layer, the electrically conductive layer and the second electrically conductive layer being spaced apart by the dielectric layer;
- the SOT-MRAM cell can comprise a second additional electrically conductive layer stacked over the second electrically conductive layer.
- the magnetic tunnel junction is formed over a first and a second vias, the first via and the second via being electrically connected to the SOT layer via, respectively, the electrically conductive layer and the second electrically conductive layer; and
- the magnetic tunnel junction is formed over a third via that is in direct contact with a bottom surface of the magnetic tunnel junction.

A second aspect of the invention relates to a semiconductor device comprising on a same substrate a first region comprising memory cells that are SOT-MRAM cells and a second region comprising memory cells that are STT-MRAM cells.

A third aspect of the invention relates to a manufacturing process of a magnetic tunnel junction for a SOT-MRAM cell, comprising the steps of patterning a magnetic tunnel junction and a SOT layer included therein with a same mask, the SOT layer being stacked and in direct contact with a dielectric layer ; forming an electrically insulating encapsulating layer covering a sidewall of the magnetic tunnel junction ; exposing a surface of the SOT layer by etching a lateral portion of the dielectric layer adjacent to the electrically insulating encapsulating layer and to the SOT layer so as to form a recess formed by a sidewall of the etched dielectric layer being inboard from the sidewall of the magnetic tunnel junction ; and forming an electrically conductive layer in direct contact with the SOT layer via the recess of the dielectric layer.

The manufacturing process according to the third aspect of the invention can be characterized as a self-aligned manufacturing processes of SOT-MRAM cells regarding the positioning of the conductive layer with regards to the SOT layer, which brings an inherent advantage over other types of manufacturing processes of SOT-MRAMs in that it allows a lower variability of the manufactured SOT-MRAM cells because there is no more variability induced by misalignement issues.

According to further non limitative features of the third aspect of the invention, either taken alone or in any technically feasible combination :
- the manufacturing method can comprise the step of providing a substrate, the patterning step can comprise the sub-steps of forming successively, and in this order, the magnetic tunnel junction, the dielectric layer and a protecting layer over the substrate, the SOT layer constituting an uppermost layer of the magnetic tunnel junction; and selectively etching the protecting layer, the dielectric layer and the magnetic tunnel junction by using the same mask;
- the manufacturing method can comprise the step of providing a substrate with a substrate dielectric layer covering a top surface thereof, the dielectric layer forming the uppermost portion of the substrate dielectric layer, the patterning step can comprise the sub-steps of forming, on the dielectric layer, the magnetic tunnel junction, the SOT layer constituting a lowermost layer of the magnetic tunnel junction ; and selectively etching the magnetic tunnel junction and the SOT layer included therein by using the same mask;
- the magnetic tunnel junction can be firstly patterned longitudinally along - a first direction and secondly patterned longitudinally along a second direction distinct from the first direction.

### FIGURES

Many other features and advantages of the present invention will become apparent from reading the following detailed description, when considered in conjunction with the accompanying drawings, in which:
[Fig. 1] Figure 1 illustrates magnetic tunnel junctions ;
[Fig. 2] Figure 2 illustrates the operation of a STT-MRAM cell ;
[Fig. 3] Figure 3 illustrates the operation of a SOT-MRAM cell ;
[Fig. 4] Figure 4 illustrates the writing operation of a conventional SOT-MRAM ;
[Fig. 5] Figure 5 illustrates a first manufacturing process of a SOT-MRAM cell according to a first embodiment of the invention ;
[Fig. 6] Figure 6 illustrates a second manufacturing process of a SOT-MRAM cell according to a second embodiment of the invention ;
[Fig. 7-1] Figure 7-1, [Fig. 7-2] Figure 7-2, [Fig. 7-3] Figure 7-3, [Fig. 7-4] Figure 7-4, [Fig. 7-5] Figure 7-5, [Fig. 7-6]

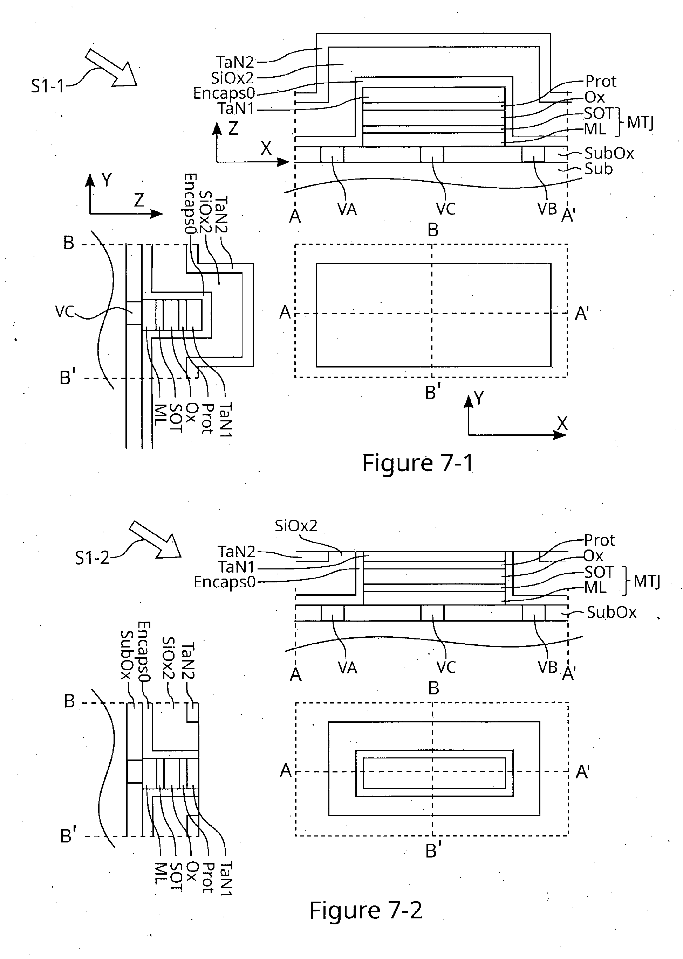

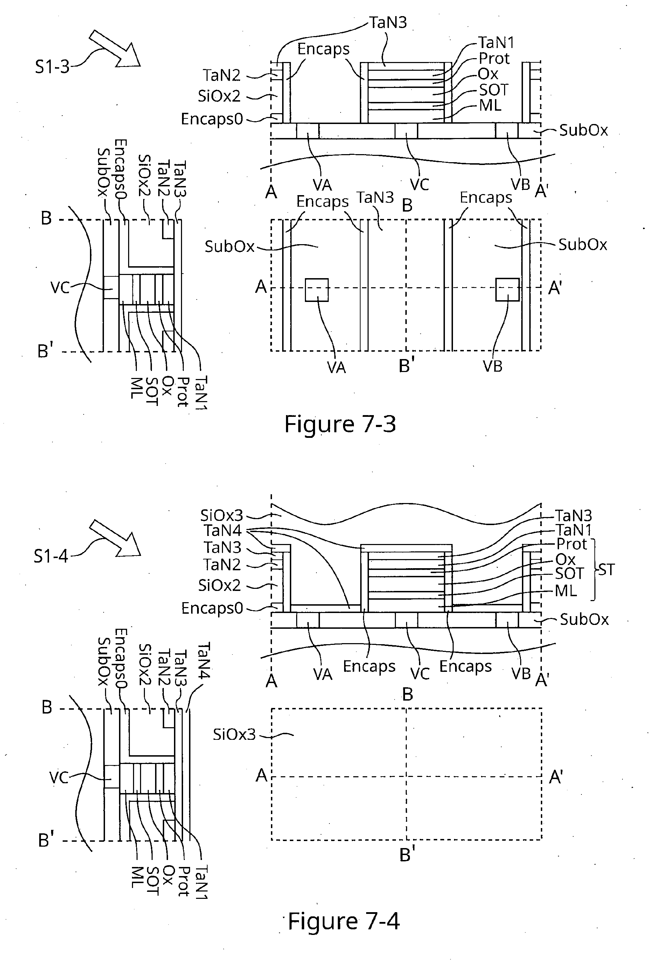

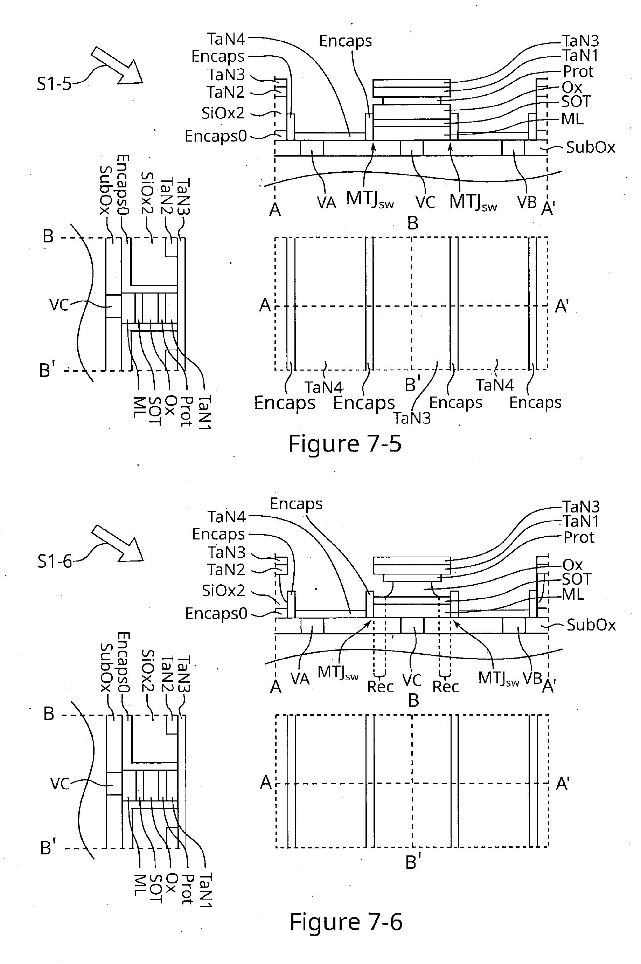

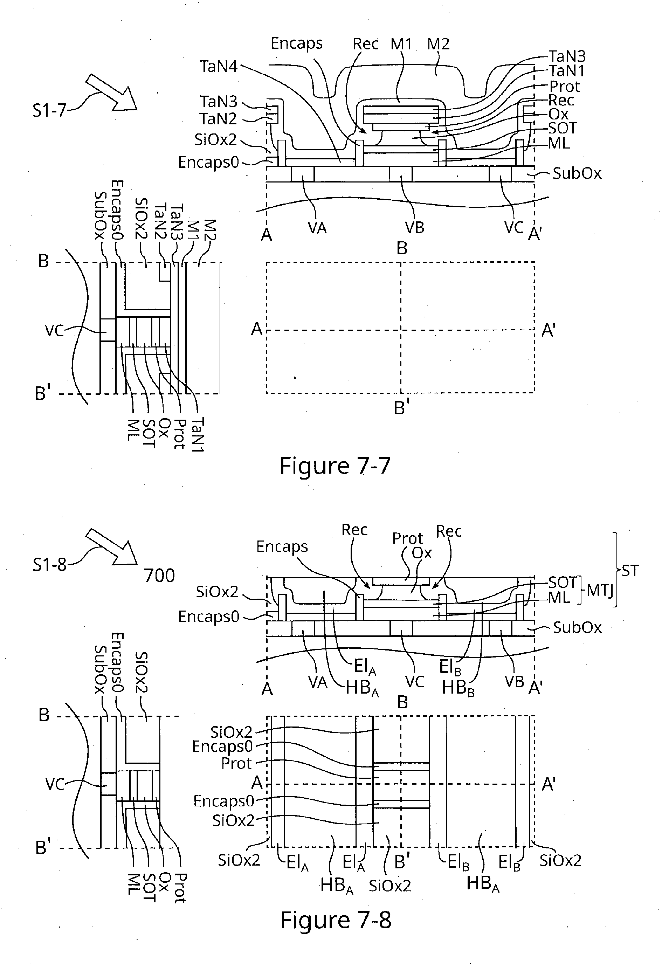

Figure 7-6, [Fig. 7-7] Figure 7-7, and [Fig. 7-8] Figure 7-8 illustrate Manufacturing Example 1 of the invention ;

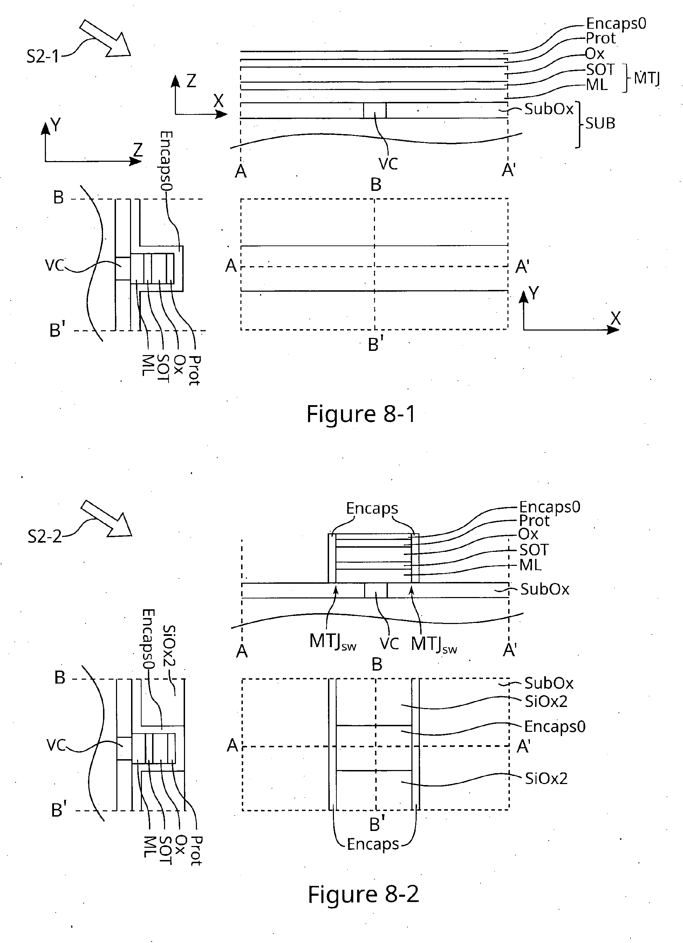

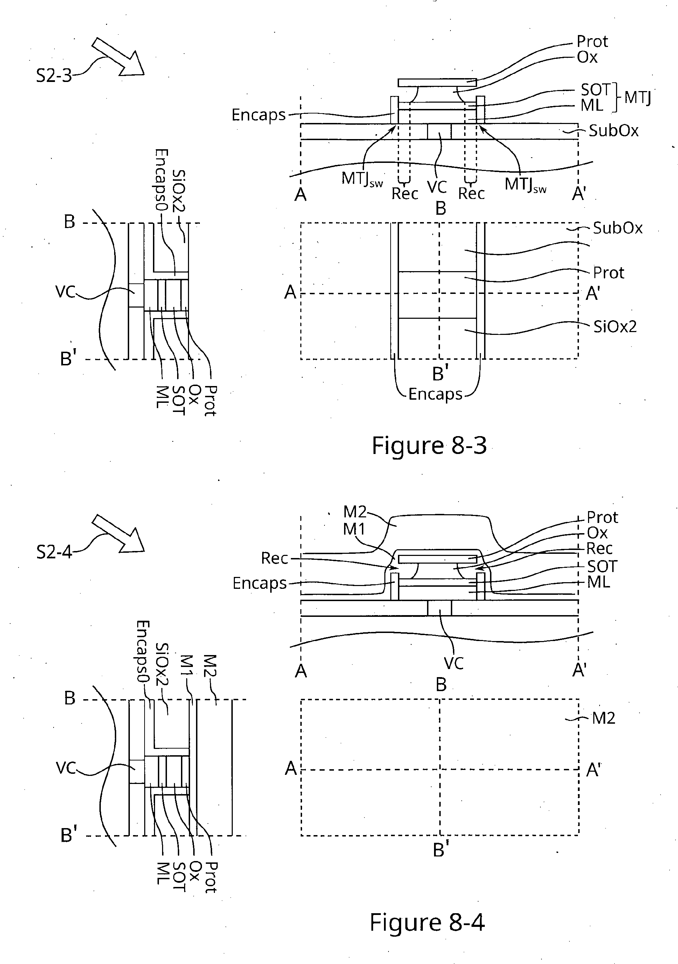

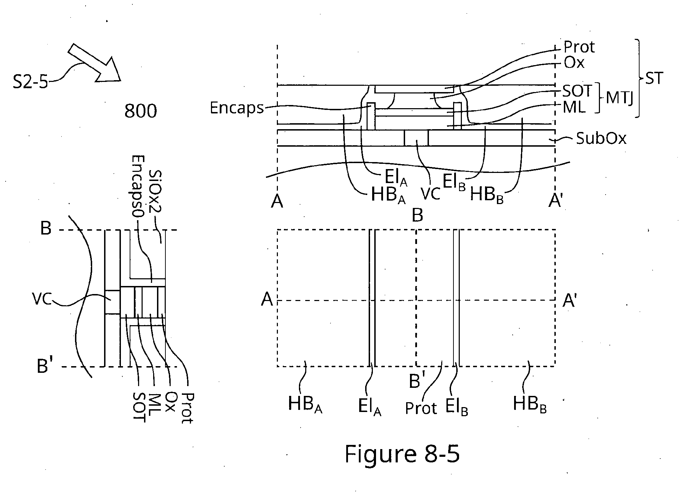

[Fig. 8-1] Figure 8-1, [Fig. 7-2] Figure 8-2, [Fig. 8-3] Figure 8-3, [Fig. 8-4] Figure 8-4, and [Fig. 8-5] Figure 8-5, illustrate Manufacturing Example 2 of the invention ;

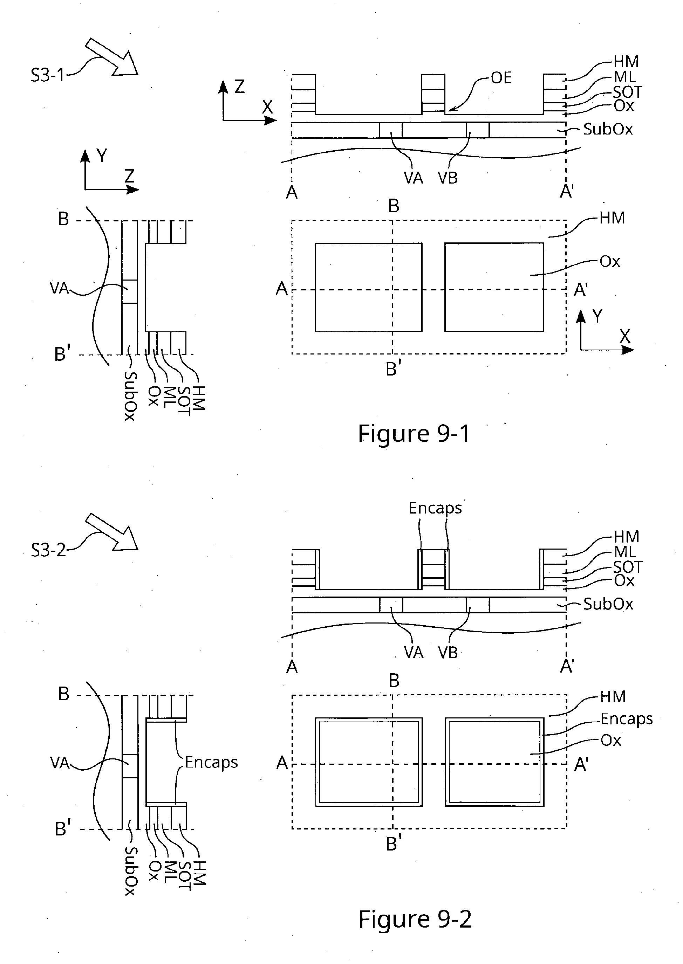

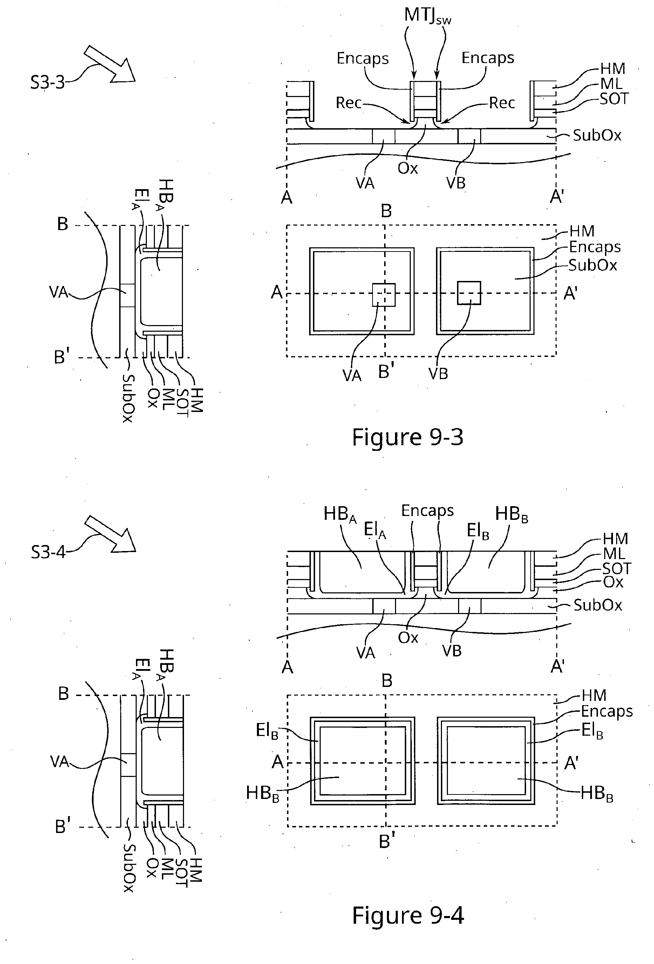

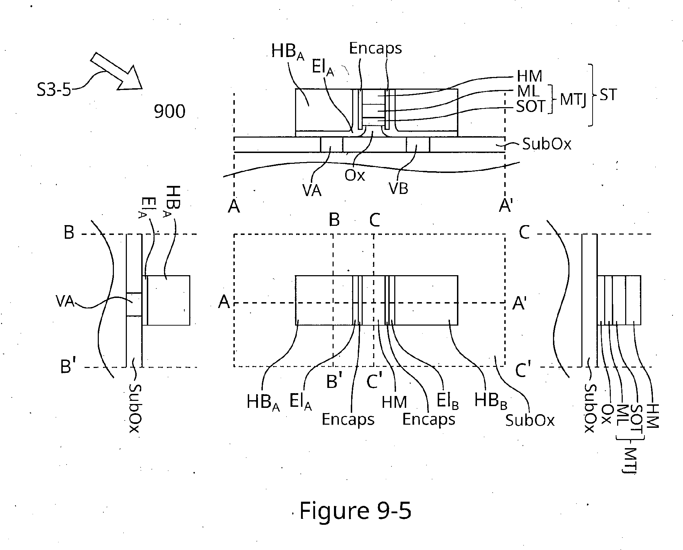

[Fig. 9-1] Figure 9-1, [Fig. 9-2] Figure 9-2, [Fig. 9-3] Figure 9-3, [Fig. 9-4] Figure 9-4, and [Fig. 9-5] Figure 9-5, illustrate Manufacturing Example 3 of the invention ;

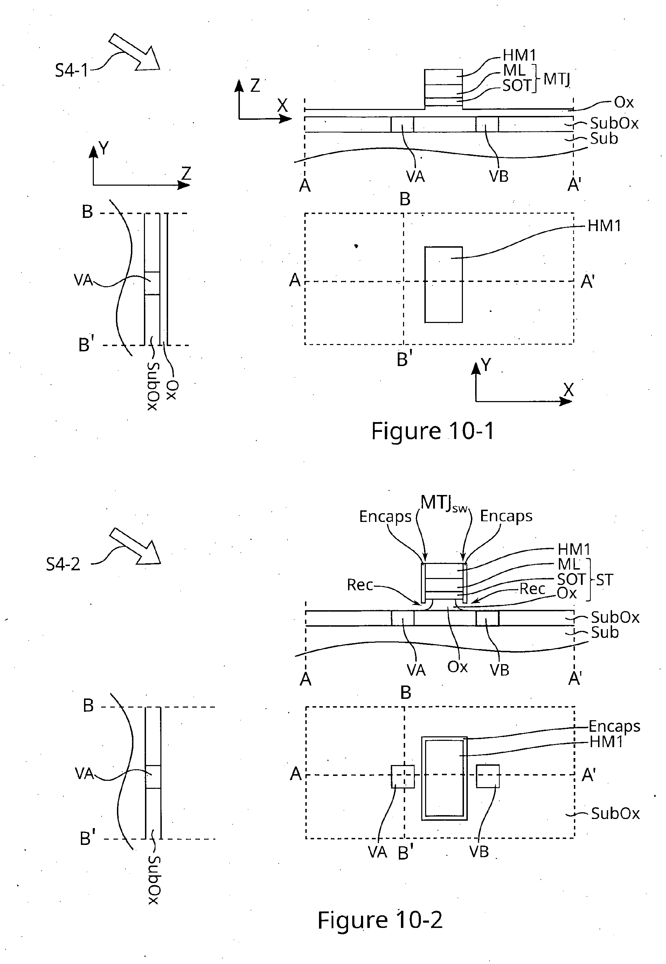

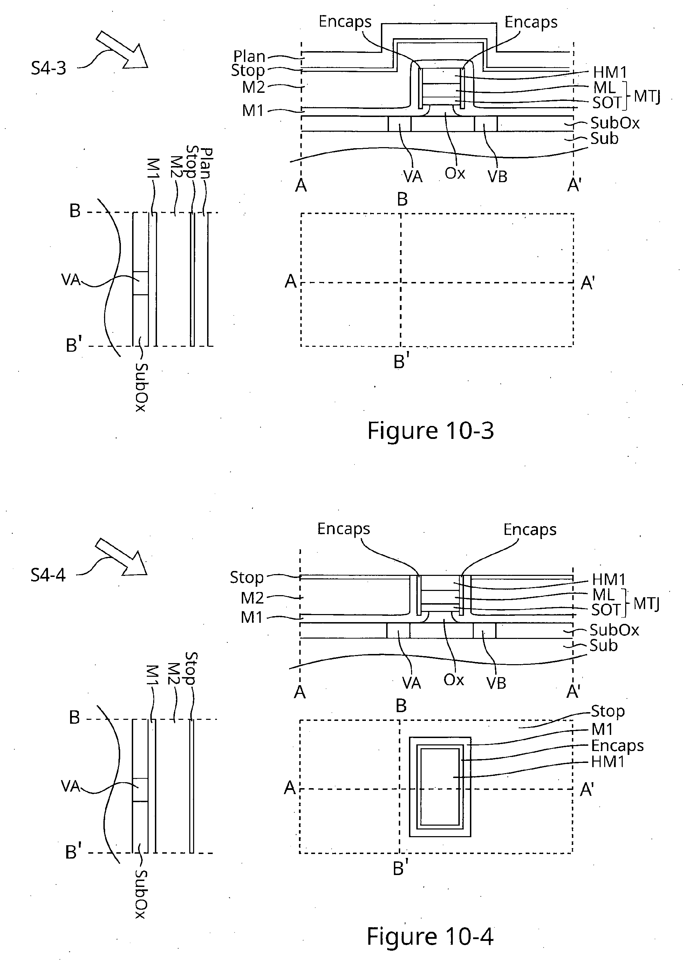

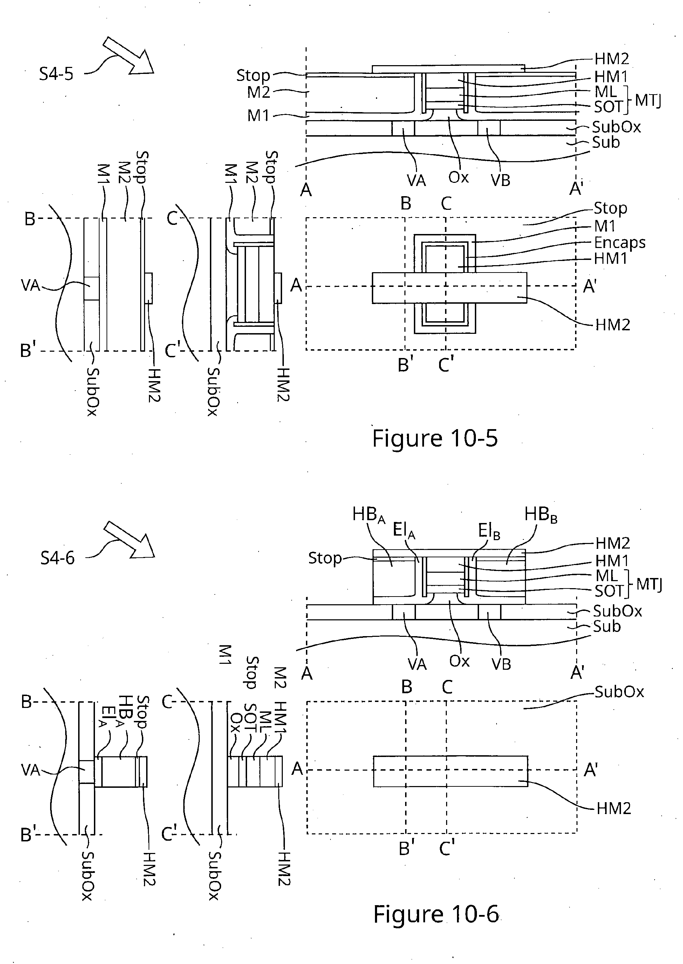

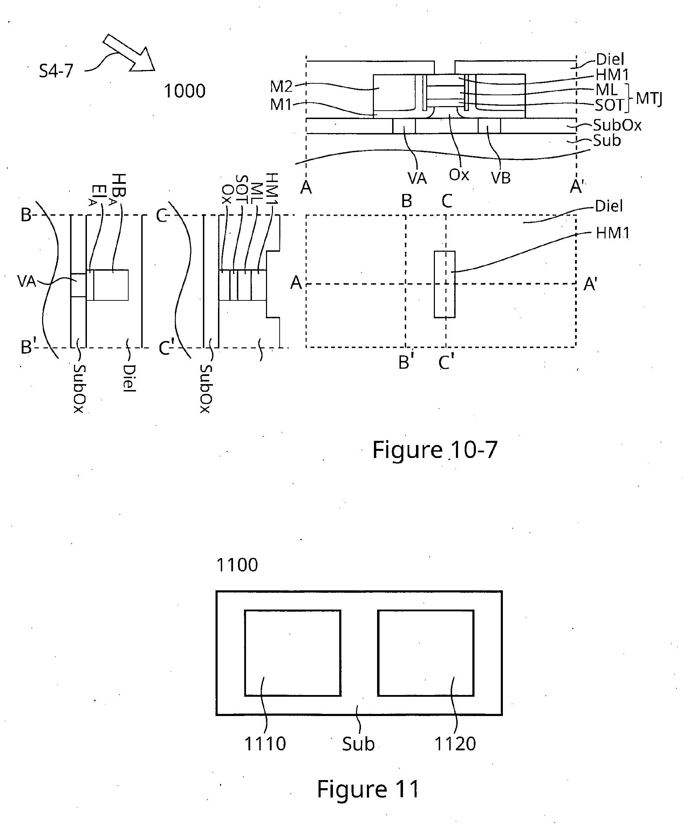

[Fig. 10-1] Figure 10-1, [Fig. 10-2] Figure 10-2, [Fig. 10-3] Figure 10-3, [Fig. 10-4] Figure 10-4, [Fig. 10-5] Figure 10-5, [Fig. 10-6] Figure 10-6, and [Fig. 10-7] Figure 10-7, illustrate Manufacturing Example 4 of the invention ;
[Fig. 11] Figure 11 illustrates an electronic device according to the invention;

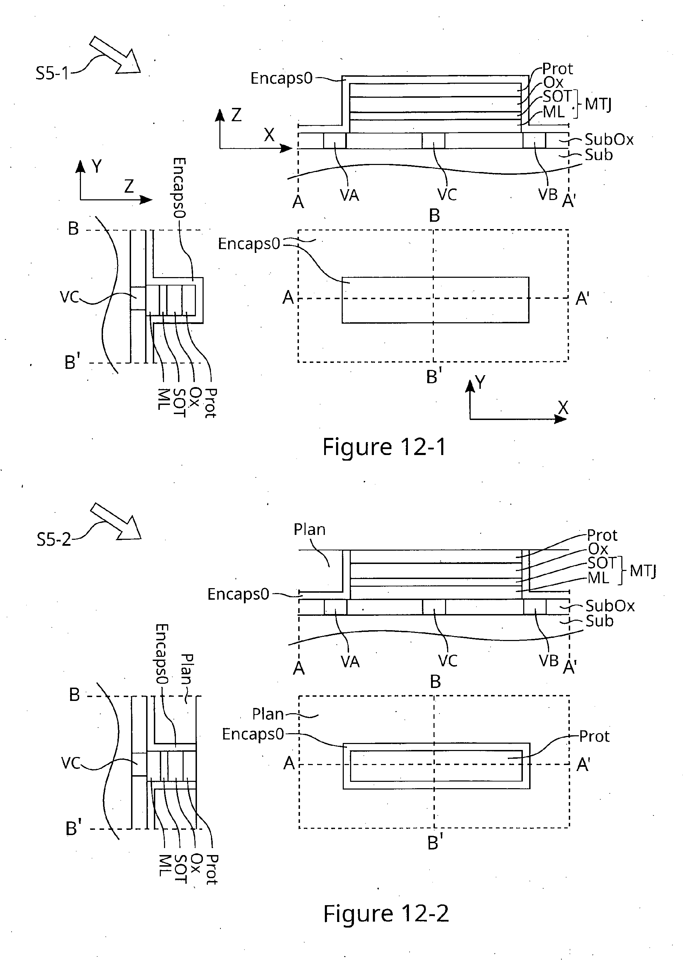

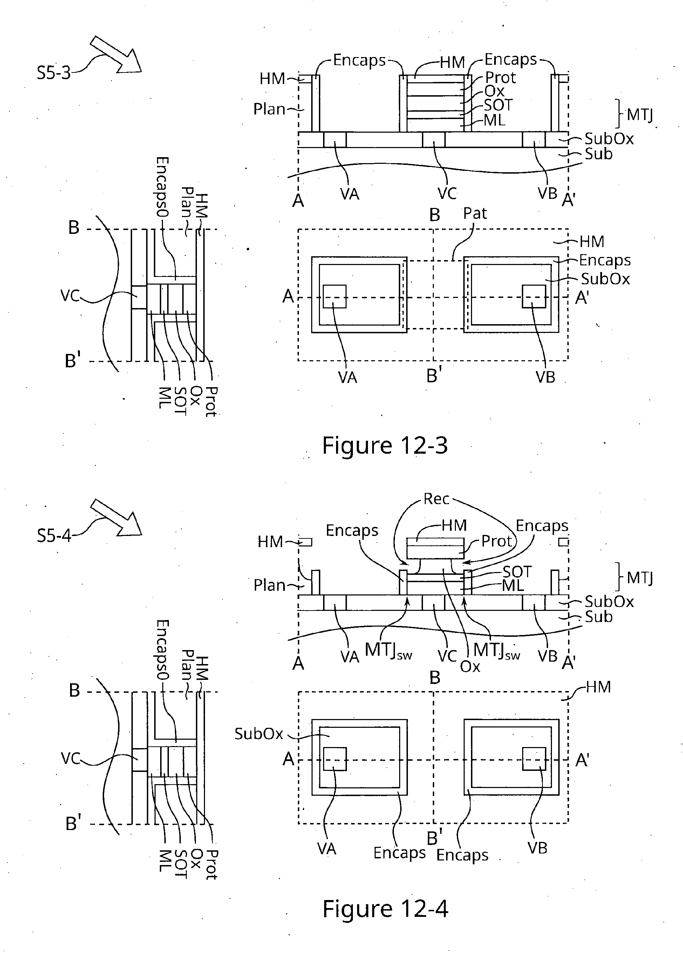

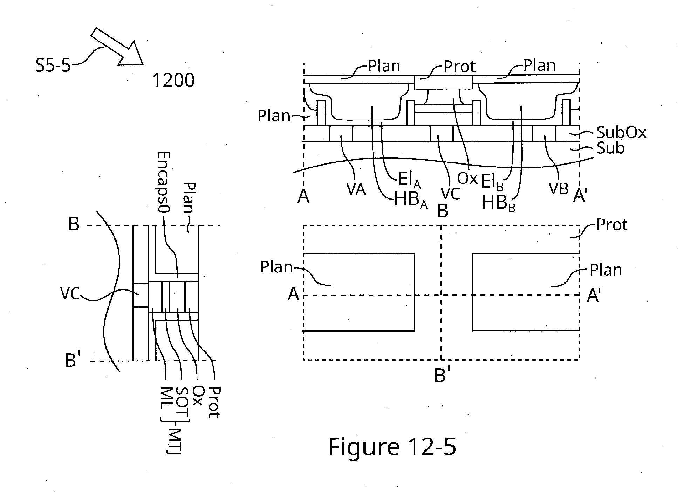

[Fig. 12-1] Figure 12-1, [Fig. 12-2] Figure 12-2, [Fig. 12-3] Figure 12-3, [Fig. 12-4] , Figure 12-4, [Fig. 12-5] Figure 12-5 illustrate Manufacturing Example 5 of the invention.

Figs 7-1 to 7-8, 8-1 to 8-5, 9-1 to 9-5, 10-1 to 10-7 and 12-1 to 12-5 each comprise a plan view parallel to a plane defined by axes X and Y, a cross-section view taken along a segment AA' of the plan and parallel to a plane defined by axes X and Z, and a cross-section view taken along a segment BB' (and optionally another cross-section view taken along a segment CC') of the plan view and parallel to a plane defined by axes Y and Z.

Axes X, Y and Z define a three-dimensional orthogonal reference frame and, for explanation purposes, the plan view is considered as horizontal and axis Z is considered as defining the vertical direction.

The figures are schematic representations that, for the sake of clarity, are not drawn to scale and, in particular, thicknesses of layers along axis Z are not to scale compared to lateral dimensions along axis X and axis Y.

Same references on the figures or in the descriptions may be used for elements of same nature, i.e. having same functions and that can be made of same materials with the same geometrical characteristics, and explanations pertaining a given element in an embodiment or example can be applied to another element having a same reference in another embodiment or example.

### DETAILED DESCRIPTION OF SPECIFIC EMBODIMENTS OF THE INVENTION

A SOT-MRAM cell according to the invention is characterized by the fact that an electric contact is established with the SOT layer via a sidewall of a patterned stack comprising the SOT layer.

The manufacturing process of a such a magnetic memory cell is not limited by misalignment issues of photolithography because it relies on a self-aligned structure.

In addition, an optional ferromagnetic layer having a sidewall facing a sidewall of the magnetic tunnel junction and separated thereof by at least an electrically insulating encapsulating layer can ensure the function of a hard bias magnet whose purpose is to magnetically bias the free ferromagnetic layer of the magnetic tunnel junction, with the advantage of having this hard bias magnet ideally positioned horizontally and vertically, close to the free ferromagnetic layer.

The invention can be practically carried out according to two distinct embodiments.

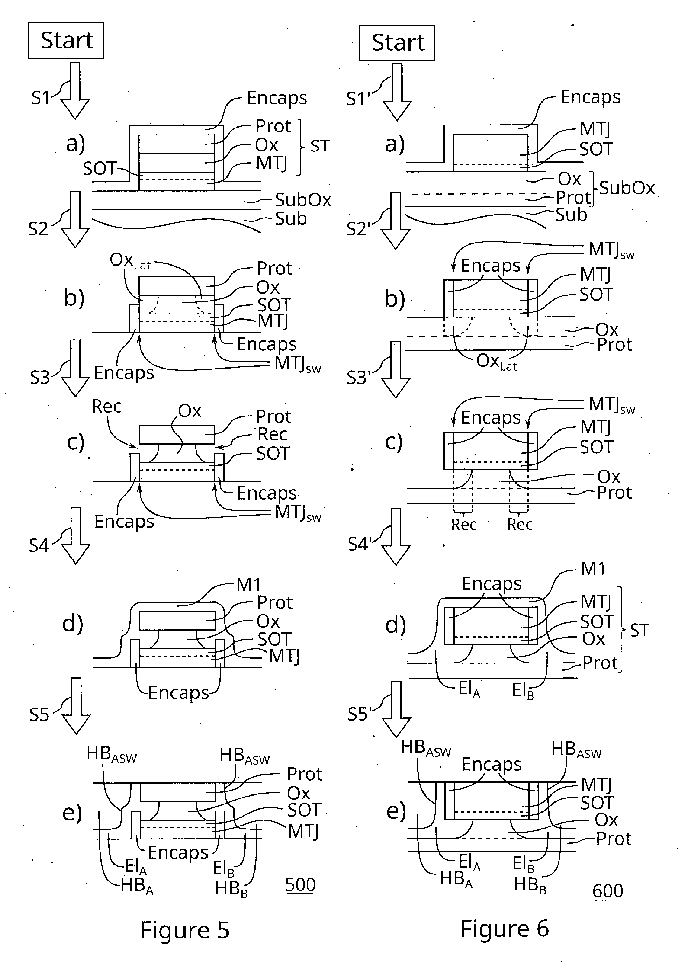

In a first embodiment, the magnetic memory cell and its manufacturing process are based on a top-SOT structure, applicable in so-called bottom-pinned MTJ in which the pinned ferromagnetic layer is placed below the tunnel layer and the SOT layer constitutes an uppermost layer of the MTJ, two electric contacts being made by direct contact of two electrically conductive layers with two respective opposite extremities of the SOT layer, at the top surface thereof, as generically illustrated by Fig. 5 and in more specific examples by Figs. 7-1 to 7-8, 8-1 to 8-5 and 12-1 to 12-5.

In a second embodiment, the magnetic memory cell and its manufacturing process are based on a bottom-SOT structure, applicable in so-called top-pinned MTJ in which the pinned ferromagnetic layer is placed above the tunnel layer and the SOT layer constitutes a lowermost layer of the MTJ, two electric contact being made by direct contact of two electrically conductive layers with two respective opposite extremities of the SOT layer, at the bottom surface thereof, as generally illustrated by Fig. 6 and in more specific examples by Figs. 9-1 to 9-5 and 10-1 to 10-7.

In this description, thicknesses of the layers deposited through the disclosed processes are shown in brackets, but are merely indicative and can be adapted according the specific structure that a practitioner may targeting.

Similarly, even though the examples below may mention specific materials, the practitioner will understand that they are not intended to limit the scope of this application, and may choose alternative materials appropriate for their intended functions.

In both embodiments, the SOT layer and other layers forming the MTJ, such as the free ferromagnetic layer Ferro_{f}, are patterned in a same process of an anisotropic vertical etching process with a hard mask defining the shape of the MTJ, so that sidewalls of the SOT layer and of the free ferromagnetic layer Ferro_{f} are parts of sidewalls MTJsw of the MTJ.

Further, except otherwise specified, any process conventionally employed in the semiconductor industry may be used to perform the disclosed steps of manufacturing, as will be understood by the skilled technician in the field.

### First embodiment - top-SOT structure

Figure 5 illustrates a SOT magnetic memory cell 500 having a top-SOT structure in which the SOT layer SOT constitutes an uppermost layer of a magnetic tunnel junction MTJ, and a manufacturing process thereof starting at an initial state Start and resulting in successive structures indicated by a) to e) in this order, generic to a variety of manufacturing processes envisioned by the inventors.

At a), Fig. 5 illustrates a structure resulting from (i) a step S1 of patterning a stack ST comprising a magnetic tunnel junction layer MTJ including a SOT layer SOT, a dielectric layer Ox and a protecting layer Prot over a substrate Sub, the dielectric layer Ox being interposed between and in direct contact with each of the SOT layer SOT and the protecting layer Prot ; and (ii) forming an electrically insulating encapsulating layer Encaps over the substrate Sub and the patterned stack ST.

Here, the structure resulting from the process are illustrated without overetching of layer SubOx that may result, voluntarily or not, of patterning the stack ST, but it is common for such overetching to occur, as illustrated by overetching OE of Fig. 9-1.

This remark applies to all the processes described in the present document, and in particular to the patterning of the magnetic tunnel junction MTJ, and in the case of bottom-SOT structures may be made useful to vertically align a magnetic hard bias layer with the magnetic tunnel junction.

Preferably, the dielectric layer Ox and the electrically insulating encapsulating layer Encaps can be etched selectively with regard to one another, for example, by employing silicon oxide as the dielectric layer Ox and silicon nitride as' the electrically insulating encapsulating layer Encaps, but the invention is not limited to this example.

Also, the protecting layer has for function to prevent etching of a top surface of the dielectric layer Ox when lateral portions of this dielectric layer Ox are etched (except, of course, lateral portions of the top or bottom surface).

This effect can be obtained by using for the layer Prot a material having a lower etching rate than the layer Ox with respect to an etching process used to etch lateral parts of the layer Ox, or by using a layer or a structure thick enough to protect the top or bottom surface of the layer Ox.

The substrate Sub can be a semiconductor substrate carrying circuitry intended to control the magnetic memory cell, this circuitry being covered with a dielectric layer SubOx in which electrical connections such as vias may be formed.

The SubOx layer may be formed from dielectric materials, such as silicon oxide SiOx, silicon carbide SiC, SiCO(H) composite films or other insulating materials used in advanced microelectronics.

The magnetic tunnel junction MTJ has a multilayer structure, and comprises a plurality of layers intended to form a magnetic tunnel junction as conventionally known, comprising at least a free ferromagnetic layers Ferro_{f} and a pinned ferromagnetic Ferroₚ with an insulating tunnel layer Ins interposed therebetween as explained previously, and in the present case of an SOT-MRAM, a spin-orbit interaction active layer or SOT layer, designated as SOT in the figures, the SOT layer being in direct contact with the free ferromagnetic layer Ferro_{f}.

Each of these layers can comprises multiple layers as well-known in the field.

The magnetic tunnel junction MTJ in this documents should not be construed as merely comprising the two ferromagnetic layers, the insulating tunnel layer and the SOT layer, but as a complex structure comprising layers used for ensuring the operation of memory cell and layers required for ensuring electrical connection and or/required for the manufacturing process, as already mentioned in the Background section.

In this top-SOT structure embodiment, a spin-orbit interaction active layer, or SOT layer, constitutes the uppermost layer of the magnetic tunnel junction MTJ, and is in direct contact with the dielectric layer Ox.

At b), Fig. 5 illustrates a structure resulting from a step S2 of anisotropically etching the electrically insulating encapsulating layer Encaps so as to remove this layer from horizontal surfaces and let it remain on sidewalls MTJsw of the magnetic tunnel junction MTJ and, in this illustrated case, part of the dielectric layer Ox.

The important point is that the electrically insulating encapsulation layer Encaps has to cover the sidewalls of the insulating tunnel layer so as to prevent formation of a shortcircuit between the two ferromagnetic layers of the magnetic tunnel junction MTJ in subsequent manufacturing steps, as well as sidewalls of the free ferromagnetic layer Ferro_{f} from adverse effects of the following process steps.

At c), Fig.5 illustrates a structure resulting from a step S3 of etching lateral parts (Ox_{Lat}) of the dielectric layer Ox adjacent to the electrically insulating encapsulation layer Encaps and to the magnetic tunnel junction MTJ so as to define recesses Rec formed by sidewalls of the etched dielectric layer Ox being inboard from sidewalls of the magnetic tunnel junction MTJ_{sw}.

It can also be said that the dielectric layer (Ox) presents recesses (Rec) formed by sidewalls of the dielectric layer (Ox) being inboard from sidewalls of the SOT layer (SOT).

The protecting layer Prot acts during the etching as a protection of a top surface of the dielectric layer Ox, so that etching of the dielectric layer Ox progressed form its lateral portions, only lateral portions (comprising parts of the top and bottom surfaces of the layer Ox) of this dielectric layer Ox were etched away.

Importantly, etching lateral parts of layer Ox exposes top surface portions of layer SOT.

This geometry, with the dielectric layer (Ox) presenting recesses (Rec) formed by sidewalls of the dielectric layer (Ox) being inboard from sidewalls of the SOT layer (SOT) and/or of the magnetic tunnel junction MTJ_{sw}, allows a direct access to the SOT layer SOT, and in particular allows forming a direct electrical connection to layer SOT.

At d), Fig 5 illustrates a structure resulting from a step S4 of forming a conformal first electrically conductive layer M1, using a deposition process leading to a conformal deposition of a conductive material, a portion of which covers and is in direct contact with the top surface of the SOT layer SOT and the electrically insulating encapsulating layer Encaps.

In contrast to a directional deposition method such as sputtering or evaporation, a conformal deposition process allows depositing a continuous electrically conducting layer reaching and covering inside surfaces of the recesses Rec over which the protecting layer Prot overhangs, to directly contact and cover portions of layer SOT made accessible by the isotropic etching of lateral parts of the dielectric layer Ox.

Suitable deposition methods are for example Chemical Vapor Deposition or CVD and atomic layer deposition or ALD.

At e), Fig. 5 illustrates a structure resulting from a step S5 of forming a second conductive layer directly on top of the layer M1 and of patterning together these two layers, for example by a chemical mechanical polishing process eliminating at a same time these two conductive layers down to a top surface of the protecting layer Prot.

The electrically conductive layer M1 is patterned in such a way as to form two separated electrodes El_{A} and El_{B} in direct contact with respective opposite extremities of the SOT layer SOT via the recesses Rec, and spaced apart from one another by the dielectric layer Ox, as illustrated.

Due to the fabrication process detailed above, the two electrodes El_{A} and El_{B} cover and are in direct contact with the electrically insulating encapsulating layers Encaps.

At the time of patterning the first conductive layer, the second conductive layer can also be patterned to form a pair of electrically conductive layers HB_{A} and HB_{B} stacked respectively directly onto separated electrodes El_{A} and El_{B}.

The conductive layers HB_{A} and HB_{B} can have for function to reduce the electrical resistance of the electrical connections to the magnetic tunnel junction.

In addition, in the case where the conductive layers HB_{A} and HB_{B} comprise a ferromagnetic material, they can form magnets optionally used as magnetic hard biases to magnetically bias the free ferromagnetic layer of the'magnetic tunnel junction and enhance control over the switching of its magnetization.

An advantage of such a structure is that these magnets are ideally located : a simple adjustment of their thickness insures that they occupy a same vertical level as magnetic tunnel junction MTJ and in particular a same vertical level as free ferromagnetic layer Ferro_{f}, having sidewalls HB_{ASW} facing and in close proximity to the sidewalls MTJsw of the magnetic tunnel junction MTJ and of the free ferromagnetic layer Ferro_{f}, only separated thereof by the thickness of the electrically insulating encapsulating layer Encaps and of the conformal conductive layer M1.

Also, optionally overetching layer SubOx in a controlled way when patterning the stack ST could allow adjusting the vertical position of the magnets, with the purpose of insuring that they occupy a same vertical level as magnetic tunnel junction MTJ and in particular a same vertical level as free ferromagnetic layer Ferro_{f} for optimal bias.

To complete the MRAM cell, connections to bottom parts of the magnetic tunnel junction MTJ and the electrodes El_{A} and El_{B} could be formed beforehand, for example as vias embedded in layer SubOx, similarly to vias VA to VC of Fig. 7-8.

Conversely, an electrical contacts may be created in q conventional manner from a top of the structure after formation of the magnetic tunnel junctions and the electrodes El_{A} and El_{B}.

A variety of specific processes can be envisioned to implement the generic process described above; in the following, some examples are detailed.

### First embodiment - Manufacturing Example 1

Figures 7-1 to 7-8 illustrate a Manufacturing Example 1 of a SOT-MRAM cell 700 having a top-SOT structure as generically described in Fig. 5.

The first step of the manufacturing process consists in providing (Start) a semiconductor substrate Sub equipped with a circuitry intended to control an MRAM.

The substrate Sub is provided covered with dielectric layer SubOx in which electrical connections are formed, in the present examples, three vias VA, VB and VC are provided, for example obtained by a conventional Damascene process.

It is to be noted that with this geometry, there is no need of an additional via coming from the top of the magnetic tunnel junction MTJ for connecting the considered MRAM cell to the circuitry provided on the substrate and intended for its control.

An important advantage of this is that the SOT-MRAM cell size can be reduced.

After providing the substrate, a step S1-1 is carried out, that results in the structure illustrated by Fig. 7-1, and that. comprises a first sub-step that consists in successively depositing, onto layer SubOx, a layer ML that is a multilayer comprising at least two ferromagnetic layers Ferro_{f} and Ferroₚ and an insulating tunnel layer Ins interposed therebetween, a SOT layer SOT forming an magnetic tunnel junction MTJ (30 nm) together with the multilayer ML, a dielectric layer Ox such as a first silicon oxide layer (40 nm) preferably a TEOS silicon oxide, a silicon nitride layer (20 nm) as a layer Prot, and a first tantalum nitride layer TaN1 (50 nm), in this order.

Instead of using tantalum ntitride for layer TaN1, one may choose a dielectric material such as SiC.The step S1-1 comprises a second sub-step, that consists in forming a first hard mask from the layer TaN1, and etching successively the layers Prot, Ox, SOT and ML so as to form a patterned stack of these layers on the substrate, located on top of one only of the vias, the via VC in the figure, so that the via VC is in direct and electrical contact with the magnetic tunnel junction MTJ.

The first hard mask comprises a first pattern elongated along axis X, such as a rectangle having long sides parallel to axis X and short sides parallel to axis Y, the long sides being longer that the short sides.

The step S1-1 comprises a third sub-step, that consists in forming an electrically insulating encapsulation layer Encaps0 using a deposition process resulting in a conformal layer, for example of silicon nitride (20 nm), and then forming successively in this order another silicon oxide layer SiOx2 (70 nm) on the encapsulation layer Encaps0, thick enough to have a top surface at approximatively a same horizontal level as the layer Prot, and a second tantalum nitride layer TaN2 (50 nm).

Next, a step S1-2 is carried out, that consists in etching a top part of the stack of layers obtained through step S1-1, by chemical mechanical polishing down to a top surface of the part of layer TaN2. that does not overlap with the magnetic tunnel junction MTJ, which results in the structure illustrated by Fig. 7-2.

In a step S1-3 comprising a first sub-step of depositing another tantalum nitride layer TaN3 over the structure resulting from the step S1-2, patterned to form a second hard mask (eventually integrating parts of layers TaN1 and TaN2), and etching successively the layers Prot, OX, SiOx2, SOT, ML and Encaps0 by anisotropic etching.

As for layers TaN1, TaN2 and TaN3, materials other than tantalum nitride may be employed, such as tantalum Ta, titanium Ti, or titanium nitride TiN.

The second hard mask comprises a second pattern elongated along axis Y, such as a rectangle having long sides parallel to axis Y and short sides parallel to axis X, the long sides being longer that the short sides.

Here, axes X and Y represent respectively a first and a second directions that are perpendicular with respect to one another, but other angular differences between these directions may be employed as long as these directions are distinct from one another, meaning in this document that they form an angle of at least 25 degrees from one another, preferably at least 40 degrees, more preferably at least 60 degrees, even more preferably at least 85 degrees.

Notably, the extension of the second mask axis X is significantly shorter that an extension of the first mask along axis X and/or shorter than the distance separating vias VA and VB, so as to easily (i.e. without difficulty due to alignment issues in a photolithographic, step) form an island-shaped structure comprising the layers SOT, ML, Ox and Prot between vias VA and VB without the structure contacting them.

The second hard mask is also designed to clear access to the vias VA and VB while intersecting the stack patterned in step S1-1.

The step S1-3 comprises a second sub-step that consists in forming another electrically insulating encapsulation layer similarly to Encaps0, and removing this layer from horizontal portions of the structure while preserving it on vertical surfaces by means of an anisotropic etching, so as to form spacers, or encapsulating sidewalls Encaps, on side surfaces of the layers Prot, Ox, SOT and ML, and to obtain the structure illustrated by Fig. 7-3.

Next, a step S1-4 consists in depositing an electrically conductive fourth tantalum nitride layer TaN4 by using a directional deposition method so as to deposit this layer on horizontal surfaces only (if needed, one can add a short isotropic etch of the metal to remove any unwanted deposition on the sidewalls), i.e. the top surface of the patterned stack resulting from step S1-3 and onto the vias VA and VB and their surrounding areas at the bottom of the stack comprising the magnetic tunnel junction.

In addition, a third oxide layer SiOx3 is deposited onto the TaN4 layer, thick enough to totally fill cavities of the structure so as to be used as a planarization layer, as illustrated in Fig. 7-4.

Next, a step S1-5 consists in applying a chemical mechanical polishing to the structure of Fig. 7-4, for planarization down to, at least, top surfaces of the encapsulating sidewalls Encaps, removing top parts of the fourth tantalum nitride layer TaN4 and the third silicon oxide layer SiOx3.

Then, top parts of the remaining oxide layer SiOx3 and of the encapsulating sidewalls Encaps can be further etched down, for example by an isotropic etching of oxide layer SiOx3 followed by an anisotropic etching of the encapsulating sidewalls Encaps, keeping in mind that the encapsulating sidewalls Encaps have to remain at least on sidewalls MTJsw of the tunneling insulating tunnel layer for covering at least sidewalls of layer ML and of layer SOT, but needs to be etched sufficiently to allow access to the dielectric layer Ox.

An additional isotropic etching specific to layer Prot may be performed to facilitate access to layer Ox, resulting in the structure illustrated by Fig. 7.5.

Next, a step S1-6 consists in etching lateral parts of the dielectric layer Ox adjacent to the encapsulating sidewalls Encaps and to layer SOT so as to define recesses Rec formed by a sidewall of the etched oxide layer being inboard from sidewalls of layer SOT.

Afterwards, remaining parts of the third silicon oxide layer SiOx3 are etched away, resulting in the structure illustrated by Fig. 7-6; during this operation, the fourth tantalum nitride layer TaN4 protects the vias VA and VB and prevents overetching the SubOx layer, overetching which may provoke a short circuit in a subsequent step.

Next, a step S1-7 comprises a fist sub-step of forming a conformal first metal layer M1 (tantalum or tungsten, 10 nm), using a deposition process such as chemical vapor deposition, leading to a conformal and continuous deposition of a conductive material allowing to form the metal layer onto inner surfaces of the recesses Rec and forming a direct and electrical connection with the SOT layer SOT, as well as with the vias VA and VB through the electrically conductive TaN4 layer, as illustrated in Fig. 7-7.

In a second sub-step of step S1-7, a second metal layer M2 is deposited directly onto the first metal layer M1, in this example filling cavities of the structure, as illustrated in Fig. 7-7, but the total filling of the cavities is not mandatory.

When the second metal layer M2 is intended to form magnets used to magnetically bias the free ferromagnetic layer Ferro_{f}, it may comprise any one of Co, Fe, Ni, CoFeB, NiFe, CoFe, CoPt, CoCrPt and their alloys.

Also, the second metal layer M2 is preferably a stack of layers, comprising for example a seed layer and a cap layer sandwiching a core ferromagnetic layer, as is well known in the field.

Next, a step S1-8 comprises a chemical mechanical polishing to grind down the structure down to a top surface of the layer Prot, resulting in forming two distinct electrodes El_{A} and El_{B} from the first metal layer M1, each connected to a respective side of the SOT layer SOT and a respective recess Rec, and two distinct electrically conductive layers HB_{A} and HB_{B} are formed from the metal layer M2, resulting in the structure of an MRAM cell 700 illustrated in Fig. 7-8.Functions of the electrodes El_{A} and El_{B} and the electrically conductive layers HB_{A} and HB_{B} have already been explained in relation to Fig. 5 at e).

In this example, the multilayer ML that comprises a pair of ferromagnetic layers is directly connected to the via VC, and is connected to the vias VA and VB through the SOT layer SOT and, respectively, the electrodes El_{A} and El_{B}, which allows connection to an electronic circuit by conventional means for operation of the SOT-MRAM cell in a fashion illustrated in Fig. 3.

In terms of functionality, vias VA, VB and VC of MRAM cell 700 correspond respectively to vias V2, V3 and V1 of MRAM cell 300 of Fig. 3.

Still, for the connection to the electronic circuit, other electrical paths may be considered and implemented, without departing form the present invention, as will be illustrated in the following example.

### First embodiment - Manufacturing Example 2

Figures 8-1 to 8-5 illustrate a Manufacturing Example 2 of an MRAM cell 800 having a top-SOT structure as generically described in Fig. 5.

The first step of the manufacturing process consists in providing a semiconductor substrate Sub equipped with a circuitry intended to control an MRAM, with a single via VC embedded into the layer SubOx covering the substrate Sub.

After providing the substrate, a step S2-1 is carried out, that results in the structure illustrated by Fig. 8-1, and that comprises a first sub-step of successively depositing, onto layer SubOx, a multilayer ML, a SOT layer SOT, a first silicon dielectric layer Ox, and a diamond-like carbon layer as the protective layer Prot, in this order.

The step S2-1 comprises a second sub-step, that consists in forming a first hard mask from the layer Prot, and etching successively the layers Ox, SOT and ML so as to form a patterned stack of these layers on the substrate, located on and in direct contact with the top surface of the via VC.

The first hard mask comprises a first pattern elongated along an X direction, such as a rectangle having long sides parallel to axis X and short sides parallel to axis Y perpendicular to axis X, the long sides being longer that the short sides.

The first hard mask is also designed and aligned with the substrate in such a way that the patterned stack overlaps with the via VC.

The step S2-1 comprises a third sub-step, that consists in forming an electrically insulating encapsulation layer Encaps0 over the etched layers.

Next, a step S2-2 is carried out, that comprises first a conventional planarization sub-step consisting in depositing a silicon oxide layer SiOx2 as a planarization layer at least as thick as the stack comprising the layers ML, SOT, Ox and DLC and then etching a top part of this layer SiOx2 by chemical mechanical polishing.

In a second sub-step, a second hard mask is formed and employed to etch successively the layers Prot, Ox, SiOx2, SOT, ML and Encaps0 by anisotropic etching.

The second hard mask comprises a second pattern elongated along axis Y, such as a rectangle having long sides parallel to axis Y and short sides parallel to axis X, the long sides being longer that the short sides.

Notably, the extension of the second hard mask along axis X is significantly shorter that an extension of the first mask along the axis X, so as to easily (i.e. without difficulty due to alignment issues in a photolithographic step) form an island-shaped structure comprising the layers Prot, Ox, SiOx2, SOT, ML and Encaps0.

The step S2-2 comprises a third sub-step that consists in forming another electrically insulating encapsulation layer similarly to Encaps0, and removing this layer from horizontal portions of the structure while preserving it on vertical surfaces by means of an anisotropic etching, so as to form electrically insulating encapsulating sidewalls Encaps, on sidewalls of the layers Prot, Ox, SiOx2, SOT and ML, and to obtain the structure illustrated by Fig. 8-2.

Next, a step S2-3 comprises a first sub-step of etching down top parts of the encapsulating sidewalls Encaps by anisotropic etching, in such a way as to keep the sidewalls Encaps at least on sidewalls MTJsw of the tunneling insulating layer MTJ, for example by covering sidewalls of the multilayer ML and of the layer SOT as illustrated here, and so as to expose at least a part of a sidewall of the dielectric layer Ox.

The step S2-3 comprises a second sub-step that consists in in etching lateral parts of the dielectric layer Ox adjacent to the encapsulating sidewalls Encaps and to the layer SOT so as to define recesses Rec formed by sidewalls of the etched dielectric layer Ox being inboard from at least sidewalls of the layer SOT, resulting in the structure illustrated by Fig. 8-3.

Next, steps S2-4 and S2-5 of forming metal layers M1 and M2 resulting in the structure illustrated by Fig. 8-4, and then electrodes El_{A} and El_{B}, and electrically conductive layers HB_{A} and HB_{B}, are carried out, which are equivalent to steps S1-7 and S1-8 of Example 1, respectively, resulting in the MRAM cell structure 800 illustrated by Fig. 8-5.

Although not represented in Figs. 8-4 and 8-5, electrically conductive layers HB_{A} and HB_{B} are patterned by conventional means to limit their lateral extensions.

In this example, electrodes El_{A} and El_{B} are not connected to vias embedded in the dielectric layer SubOx of the substrate, the via VC being connected directly to the magnetic tunnel junction MTJ via le multilayer ML.

Electrodes El_{A} and El_{B} may be connected to control circuitry by the means of connecting vias formed on top of these electrodes or by vias embedded in layer SubOx as in Manufacturing Example 1.

In terms of functionality, via VC of MRAM cell 800 corresponds to via V1 of MRAM cell 300 of Fig. 3.

Still, for the connection to the electronic circuit, other electrical paths may be considered and implemented, without departing form the present invention, as will be illustrated in the following example.

### First embodiment - Manufacturing Example 5

Figures 12-1 to 12-5 illustrate a Manufacturing Example 5 of an MRAM cell 1200 having a top-SOT structure as generically described in Fig. 5.

The first step of the manufacturing process consists in providing a semiconductor substrate Sub equipped with a circuitry intended to control an MRAM, with three vias VA, VB and VC embedded into the layer SubOx covering the substrate Sub.

After providing the substrate, a step S5-1 is carried out, that results in the structure illustrated by Fig. 12-1, and that comprises a first sub-step of successively depositing, onto layer SubOx, a multilayer ML, a SOT layer SOT, a first dielectric layer Ox, and a dielectric layer as the protective layer Prot, in this order.

The step S5-1 comprises a second sub-step, that consists in forming a first hard mask from the layer Prot, and etching successively the layers Ox, SOT and ML so as to form a patterned stack of these layers on the substrate, located on and in direct contact with the top surface of the via VC.

The first hard mask comprises a first pattern elongated along an X direction, such as a rectangle having long sides parallel to axis X and short sides parallel to axis Y perpendicular to axis X, the long sides being longer that the short sides.

The step S5-1 comprises a third sub-step, that consists in forming an electrically insulating encapsulation layer Encaps0 over the substrate and the patterned stack.

Next, a step S5-2 is carried out, that comprises first a conventional planarization sub-step consisting in depositing a planarization layer Plan such as a silicon dioxide layer at least as thick as the stack comprising the layers ML, SOT, Ox and Prot and then etching a top part of this layer Plan by chemical mechanical polishing, in such a way as to expose the layer Prot, resulting in the structure illustrated by Fig. 12-2.

Next, a step S5-3 is carried out, that comprises a first sub-step of forming a second hard mask HM that is then employed to selectively etch successively the layers Prot, Ox, SiOx2, SOT, ML and Encaps0 by anisotropic etching.

The second hard mask comprises a second pattern, corresponding to the shape enclosed by dotted line Pat indicated in Fig. 12-3, elongated along axis Y, such as a rectangle having long sides parallel to axis Y and short sides parallel to axis X, the long sides being longer that the short sides.

Notably, the extension of the second hard mask along axis X is significantly shorter that an extension of the first mask along the axis X and/or the distance separating vias VA and VB, so as to easily (i.e. without difficulty due to alignment issues in a photolithographic step) form an island-shaped structure comprising the layers Prot, Ox, SiOx2, SOT, ML and Encaps0 between vias VA and VB without the structure contacting them.

The step S5-3 comprises a third sub-step that consists in forming another electrically insulating encapsulation layer similarly to Encaps0, and removing this layer from horizontal portions of the structure while preserving it on vertical surfaces by means of an anisotropic etching, so as to form electrically insulating encapsulating sidewalls Encaps, on sidewalls of the layers Prot, Ox, SiOx2, SOT and ML, and to obtain the structure illustrated by Fig. 12-3.

Next, a step S5-4 comprises a first sub-step of etching down top parts of the encapsulating sidewalls Encaps by anisotropic etching, in such a way as to keep the sidewalls Encaps at least on sidewalls MTJsw of the tunneling insulating layer MTJ, for example by covering sidewalls of the multilayer ML and of the layer SOT as illustrated here, and so as to expose at least a part of a sidewall of the dielectric layer Ox.

The step S5-4 comprises a second sub-step that consists in in etching lateral parts of the dielectric layer Ox adjacent to the encapsulating sidewalls Encaps and to the layer SOT so as to define recesses Rec formed by sidewalls of the etched dielectric layer Ox being inboard from at least sidewalls of the layer SOT, which results in the structure illustrated by Fig. 12-4.

As illustrated in Fig. 12-4, the planarization layer Plan may be etched at the time of etching lateral parts of the dielectric layer Ox, as may be for example the case when both of these layers are made of silicon dioxide.

Next, step S5-5 of forming metal layers M1 and M2, electrodes El_{A} and El_{B}, and electrically conductive layers HB_{A} and HB_{B}, is carried out, which is equivalent to steps S1-7 and S1-8 of Example 1, respectively, resulting in the MRAM cell structure 1200 illustrated by Fig. 12-5.

Functions of the electrodes El_{A} and El_{B} and the electrically conductive layers HB_{A} and HB_{B} have already been explained in relation to Fig. 5 at e).

In this example, the multilayer ML that comprises a pair of ferromagnetic layers is directly connected to the via VC, and is connected to the vias VA and VB through the SOT layer SOT and, respectively, the electrodes El_{A} and El_{B}, which allows connection to an electronic circuit by conventional means for operation of the SOT-MRAM cell in a fashion illustrated in Fig. 3.

In terms of functionality, vias VA, VB and VC of MRAM cell 1200 correspond respectively to vias V2, V3 and V1 of MRAM cell 300 of Fig. 3.

Still, for the connection to the electronic circuit, other electrical paths may be considered and implemented, without departing form the present invention, as will be illustrated in the following example.

### Second embodiment - bottom-SOT structure

Figure 6 illustrates a magnetic memory cell 600 having a bottom-SOT structure and a manufacturing process thereof resulting in successive structures indicated by a) to e) in this order, generic to a variety of manufacturing processes envisioned by the inventors.

At a), Fig. 6 illustrates a structure resulting from a step S1' of patterning a magnetic tunnel junction MTJ formed on a substrate covered with a substrate dielectric layer SubOx; and forming an electrically insulating encapsulating layer Encaps over the substrate Sub and the patterned magnetic tunnel junction MTJ.

As in the first embodiment, the magnetic tunnel junction MTJ comprises a plurality of layers intended to form a magnetic tunnel junction as conventionally known, and comprising at least a free ferromagnetic layer Ferro_{f} and a pinned ferromagnetic Ferroₚ and an insulating tunnel layer interposed therebetween, and a spin-orbit interaction active or SOT layer in direct contact with the free ferromagnetic layer Ferro_{f}.

In this bottom-SOT structure embodiment, the SOT layer constitutes the lowermost layer of the magnetic tunnel junction MTJ and is in direct contact with the substrate dielectric layer SubOx.

The substrate dielectric layer SubOx is considered as comprising a dielectric layer Ox in direct contact with the SOT layer SOT, and a protective layer Prot directly under the dielectric layer Ox, as illustrated.

At b), Fig. 6 illustrates a structure resulting from a step S2' of anisotropically etching the electrically insulating encapsulating layer Encaps so as to remove this layer from horizontal surfaces and let it remain on sidewalls MTJsw of the magnetic tunnel junction MTJ, similarly to the step S2.

The important point is that the electrically insulating encapsulation layer Encaps has to cover the sidewalls of the' insulating tunnel layer so as to prevent formation of a shortcircuit between the two ferromagnetic layers of the magnetic tunnel junction MTJ in subsequent manufacturing steps, as well as sidewalls of the free ferromagnetic layer Ferro_{f} from adverse effects of the following process steps.

At c), Fig. 6 illustrates a structure resulting from a step S3' of etching a top part of the substrate dielectric layer SubOx, with the etching of lateral portions Ox_{Lat} of the dielectric layer Ox adjacent to the electrically insulating encapsulation layer Encaps and to the magnetic tunnel junction MTJ so as to form recesses Rec formed by sidewalls of the etched dielectric layer Ox being inboard from sidewalls of the magnetic tunnel junction MTJ_{sw}, these recesses exposing bottom surface portions of the SOT layer SOT.

It can also be said that the dielectric layer Ox presents recesses Rec formed by sidewalls of the dielectric layer Ox being inboard from sidewalls of the SOT layer SOT.

A top part of the etched dielectric layer SubOx, localized below the magnetic tunnel junction MTJ and that extends down to an etching depth of the dielectric layer SubOx, as indicated by dotted line in Fig. 6, defines the dielectric layer Ox.

A bottom portion of the dielectric layer SubOx, not submitted to the etching operation, acted during the etching as a protection with regard to a bottom surface of the dielectric layer Ox, and constitutes the protecting layer Prot ensuring that only lateral portions of this dielectric layer Ox were etched away.

A patterned stack ST is constituted by the magnetic tunnel junction layer MTJ, the dielectric layer Ox and the protecting layer Prot, the dielectric, layer Ox being interposed and in direct contact with each of the SOT layer SOT and the protection layer Prot.

This geometry, with the dielectric layer Ox presenting recesses Rec formed by sidewalls of the dielectric layer Ox being inboard from sidewall of the SOT layer SOT and/or of the magnetic tunnel junction MTJ_{sw}, allows a direct access to the magnetic tunnel junction, and in particular forming a electrical connection to the SOT layer by direct contact thereto.

At d), Fig 6 illustrates a structure resulting from a step S4' of forming a conformal first electrically conductive layer M1 over the substrate, the magnetic tunnel junction MTJ and the insulating encapsulation layer Encaps, M1 being in direct contact with the SOT layer SOT.

At e), Fig. 6 illustrates a structure resulting from a step S5' of forming of a second electrically conductive layer M2 directly on top of the conformal first electrically conductive layer M1 and of patterning these layers, for example by a chemical mechanical polishing eliminating the two conductive layers down to a top surface of the magnetic tunnel junction MTJ.

The first electrically conductive layer M1 can be patterned so as to comprise two separated electrodes El_{A} and El_{B} in direct contact to respective opposite extremities of the SOT layer SOT via the recesses Rec as illustrated and spaced apart from one another by the dielectric layer (Ox), as illustrated.

Due to the fabrication process detailed above, the two electrodes El_{A} and El_{B} cover and are in direct contact with the electrically insulating encapsulating layers Encaps.

At the time of patterning the first electrically conductive layer M1, the second electrically conductive layer M2 can also be patterned to form a pair of conductive layers HB_{A} and HB_{B} stacked respectively directly onto separated electrodes El_{A} and El_{B}.

When formed in contact with the electrodes El_{A} and El_{B}, as illustrated here, the conductive layers HB_{A} and HB_{B} can have for function to reduce the electrical resistance of the electrical connections to the magnetic tunnel junction.

In addition, in the case where the conductive layers HB_{A} and HB_{B} are formed from a ferromagnetic material, they can form magnets used to magnetically bias the free ferromagnetic layer of the magnetic tunnel junction and enhance control over the switching of its magnetization.

It is also possible to adjust the process to ensure that the magnets are at a same horizontal level as the free ferromagnetic layer of the magnetic tunnel junction, for example by partially etching in a controlled manner a top portion of the layer Subox at the step S1' of patterning a stack ST.

### Second embodiment - Manufacturing-Example 3

Figures 9-1 to 9-5 illustrate Manufacturing Example 3 of a SOT-MRAM cell 900 having a bottom-SOT structure as generically described in Fig. 6.

The first step of the manufacture consists in providing a semiconductor substrate Sub equipped with a circuitry intended to control memory cells of an MRAM, with two vias VA and VB embedded in a dielectric layer SubOx covering the substrate Sub.

After'providing the substrate, a step S3-1 is carried out, that comprises a first sub-step that consists in successively depositing, onto layer SubOx, an electrically insulating dielectric layer Ox, a SOT layer SOT, a multilayer ML, a hard mask layer HM, in this order.

The step S3-1 comprises a second sub-step, that consists in patterning the hard mask layer HM to form a first hard mask, and etching successively the layers ML, SOT and partially only the layer Ox so as to form a patterned stack of these layers on the substrate in accordance with the pattern formed, by the hard mask HM, located between the vias VA and VB, resulting in the structure illustrated by Fig. 9-1.

The partial etch of layer Ox may be referred to as an over etch OE, materialized by a step coinciding with the sidewall of the layers on top of layer Ox, and is only optional.

The first hard mask comprises a first pattern Pat1 elongated along axis Y, such as a rectangle having long sides parallel to axis Y and short sides parallel to axis X perpendicular to the axis Y, the long sides being longer that the short sides.

Next, a step S3-2 is carried out, that comprises a first sub-step of depositing an electrically encapsulating layer Encaps and a second sub-step of anisotropically etching this layer to remove this layer from horizontal surfaces and let it remain on sidewalls of the layers HM, ML, SOT and Ox, resulting in the structure illustrated by Fig. 9-2.

Next, a step S3-3 of exposing vias VA and VB, defining recesses Rec, and exposing bottom surface portions of the layer SOT is carried out by isotropic etching of the layer Ox, resulting in the structure illustrated by Fig. 9-3.

Here, layer SubOx has a function and characteristics corresponding to the protecting layer Prot mentioned in the previous examples.

Next, a step S3-4 is carried out, similarly to steps S1-7 and S1-8, so as to form firstly metal layers M1 and M2, and then forming distinct electrodes El_{A} and El_{B} from the first metal layer M1, each connected to corresponding side of the SOT layer SOT, and two distinct electrically conductive layers HB_{A} and HB_{B} formed from the metal layer M2, as illustrated in Fig. 9-4.

Finally, a step S3-5 is carried out to define lateral edges of the stack ST, the electrodes El_{A} and El_{B} and the electrically conductive layers HB_{A} and HB_{B}, for example by forming a hard mask onto the structure illustrated by Fig. 9-4 and etching successively these elements by anisotropic reactive ion etching RIE, resulting in the structure of an MRAM cell 900 illustrated by Fig. 9-5.

In this example, the multilayer ML that comprises a pair of ferromagnetic layers is connected to the vias VA and VB through the SOT layer SOT and, respectively, the electrodes El_{A} and El_{B}, in direct contact with the SOT layer SOT, which allows connection to an electronic circuit by conventional means for operation of the SOT-MRAM cell in a fashion illustrated in Fig. 3.

In terms of functionality, vias VA and VB of MRAM cell 900 correspond respectively to vias V2 and V3 of MRAM cell 300 of Fig. 3.

To complete the MRAM cell, a connection to a top part of the magnetic tunnel junction could be formed in a subsequent step, for example by forming a via overlapping with the stack ST and in direct contact with the hard mask HM formed from an electrically conductive material.

Naturally, in the present situation where the vias VA and VB are in electrical contact with the electrically conductive layers HB_{A} and HB_{B}, the electrically conductive element coming into contact with the hard mask HM has to be narrow enough to avoid contacting HB_{A} and HB_{B}.

Still, other electrical paths may be considered and implemented, without departing form the present invention.

### Second embodiment Manufacturing Example 4

Figures 10-1 to 10-5 illustrates Manufacturing Example 4 of a SOT-MRAM cell 1000 having a bottom-SOT structure as generically described in Fig. 6.

The first step of the manufacture consists in providing a semiconductor substrate Sub equipped with a circuitry intended to control memory cells of an MRAM, with two vias VA and VB embedded in a dielectric layer SubOx covering the substrate Sub.

After providing the substrate, a step S4-1 is carried out, that comprises a first sub-step of successively depositing, onto layer SubOx, an electrically insulating dielectric layer Ox, a SOT layer SOT, a multilayer ML, and an electrically conductive hard mask layer HM1, in this order, so that layer Ox is in direct contact with layer SOT.

The step S4-1 comprises a second sub-step, that consists in patterning the hard mask layer HM1 to form a first hard mask, and etching successively the layers ML, SOT and partially only the layer Ox so as to form a patterned stack of these layers on the substrate in accordance with the pattern formed by the hard mask HM1, located between the vias VA and VB, resulting in the structure illustrated by Fig. 10-1.

The first hard mask comprises a first pattern Pat1 elongated along axis Y, such as a rectangle having long sides parallel to axis Y and short sides parallel to axis X perpendicular to the axis Y, the long sides being longer that the short sides.

Next, a step S4-2 is carried out, that comprises a first sub-step of depositing an electrically encapsulating layer Encaps and a second sub-step of anisotropically etching this layer to remove this layer from horizontal surfaces and let it remain on sidewalls of the layers HM1, ML, SOT and Ox.

Next, a third sub-step is carried out, that consists in exposing vias VA and VB, defining recesses Rec, and exposing bottom surface portions of the layer SOT, by isotropic etching of the layer Ox, similarly to the step S3-3, resulting in the structure illustrated by Fig. 10-2.

Here, layer SubOx has a function and characteristics corresponding to the protecting layer Prot mentioned in Manufacturing Example 3.

Next, a step S4-3 is carried out, that comprises a first sub-step similar to step S1-7, so as to form metal layers M1 and M2, and a second sub-step of forming successively a stop layer Stop and a planarization layer Plan, in this order, onto metal layer M2, the two sub-steps resulting in the structure illustrated by Fig. 10-3

Layer Stop and layer Plan can be made of any material conventionally known to be used to form respectively a stop layer and a planarization layer in a chemical mechanical polishing process.

Next, a step S4-4 is carried out, that consists in grinding down the layers Plan, M2 and M1 in a region overlapping with layer HM1 until layer HM1 is exposed, the thicknesses of the layers being designed so that this grinding depth corresponds to the vertical position of the layer Stop in other areas, resulting in the structure illustrated by Fig. 10-4, with an island-shaped stack comprising layers Ox, SOT, HM and HM1 surrounded by metal layers M1 and M2, with layers Encaps insulating, in particular, sidewalls of layer ML from the metal layers M1 and M2.

Next, a step S4-5 is carried out, that consist in forming by photolithography a second hard mask HM2 according to a second pattern elongated along axis X, such as a rectangle having long sides parallel to axis X and short sides parallel to axis Y, the long sides being longer that the short sides.

Notably, the extension of the second hard mask HM2 along axis X is significantly longer that an extension of the first mask along the axis X, so as to easily (i.e. without difficulty due to alignment issues in a photolithographic step) form an island-shaped structure comprising an intersection of the patterns of hard masks HM1 and HM2, as illustrated by Fig. 10-5.

At a step S4-6, an anisotropic etching is performed using hard mask HM2 to protect the areas of layers intended to be kept, defining simultaneously (i) lateral edges of a stack comprising the layers Ox, SOT, ML and HM1 as illustrated in particular by the cross-section CC' in Fig. 10-6, and (ii) lateral edges of electrodes El_{A} and El_{B} formed from metal layer M1 and hard biases HB_{A} and HB_{B} formed from metal layer M2 by etching these layers down to layer SubOx, resulting in the structure illustrated by Fig. 10-6.

Finally, a step S4-7 is carried out, that comprises a first sub-step of removing the second hard mask HM2, for example by a process involving a conventional chemical mechanical polishing, a second sub-step of forming a planar layer of dielectric material Diel, and a third sub-step of forming an opening in layer Diel to expose at least a part of layer HM1 to electrically contact the magnetic tunnel junction of the layer ML, which results in the formation of MRAM cell 1000 illustrated by Fig. 10-7.

In this example, the multilayer ML that comprises a pair of ferromagnetic layers is connected to the vias VA and VB through the SOT layer SOT and, respectively, the electrodes El_{A} and El_{B}, which allows connection to an electronic circuit by conventional means for operation of the SOT-MRAM cell in a fashion illustrated in Fig. 3.

In terms of functionality, hard mask HM1 and vias VA and VB of MRAM cell 1000 correspond respectively to vias V1, V2 and V3 of MRAM cell 300 of Fig. 3.

To complete the MRAM cell, a connection to a top part of the magnetic tunnel junction could be formed in a subsequent step, for example by forming a via overlapping with the stack ST and in direct contact with the hard mask HM1 formed from an electrically conductive material such as tantalum.

Still, other electrical paths may be considered and implemented, without departing form the present invention.

Notably, the MRAM structures 500, 600, 700, 800, 900, 1000 and 1200 illustrated by Figs. 5, 6, 7-8, 8-5, 9-5, 10-7 and 12-5, respectively, all benefit from a self-aligned manufacturing process, that does not require precise alignments during the operations of photolithography required to pattern layers in these fabrication processes.

Figure 11 illustrates a semiconductor device comprising on a same substrate (Sub) a first region (1110) comprising SOT-MRAM cells and a second region (1120) comprising STT-MRAM cells, these SOT-MRAM cells and STT-MRAM cells being manufactured according to any one of the manufacturing processes described hereabove.

Specifically, the STT-MRAM cells may be manufactured by any one of the manufacturing processes described above, the SOT layer being absent or replaced by a conventional electrically conductive layer.

Alternately, the STT-MRAM may have the same structure as the SOT-MRAM, including the SOT layer, but the semiconductor device may be configured to operate the MRAM cells of the second plurality of the second region as STT-MRAM cells.

In Fig. 11, the memory regions appear formed in distinct areas, but the invention is not limited to such a configuration and the two regions may be distributed on the substrate Sub in any kind of repartition, optionally imbricated within one another, as decided by the practitioner.

Thanks to the self-alignment, the conductive layers having for function to bring electrical current or to magnetically bias the magnetic tunnel junction can be optimally positioned with regards to the SOT-layer and the free ferromagnetic layer, leading to better performances, lower variability and scalability and an MRAM cell.

Each of the examples and embodiments mentioned in this document can be freely combined within technical limits understood by the practitioner in the field of the invention.

Other variations to the disclosed embodiments can be understood and effected by those skilled in the art in practicing the claimed invention, from a study of the drawings, the disclosure, and the appended claims.

## Claims

1. A SOT-MRAM cell (500, 700, 800, 1200; 600, 900, 1000) comprising :
- a magnetic tunnel junction (MTJ) including a SOT layer (SOT);
- a dielectric layer (Ox) stacked with the magnetic tunnel junction (MTJ) and in direct contact with the SOT layer (SOT) ;
- an electrically insulating encapsulating layer (Encaps) covering a sidewall of the magnetic tunnel junction (MTJ) ; and
- an electrically conductive layer (El_{A}) in direct contact with the SOT layer,
the SOT-MRAM cell being **characterized in that** :
- the dielectric layer (Ox) presents a recess (Rec) formed by a sidewall of the dielectric layer (Ox) being inboard from the sidewall (MTJsw) of the magnetic tunnel junction (MTJ) ; and
- the electrically conductive layer (El_{A}) covers the electrically encapsulating layer (Encaps) and is in direct contact with the SOT layer (SOT) via the recess (Rec) of the dielectric layer (Ox).

2. The SOT-MRAM cell according to claim 1, wherein the electrically conductive layer (El_{A}) is in direct contact with a top surface of the SOT layer (SOT).

3. The SOT-MRAM cell according to claim 1, wherein the electrically conductive layer (El_{A}) is in direct contact with a bottom surface of the SOT layer (SOT).

4. The SOT-MRAM cell according to any one of claims 1 to 3, further comprising an additional electrically conductive layer (HB_{A}) stacked over the electrically conductive layer (El_{A}).

5. The SOT-MRAM cell according to claim 4, wherein the additional electrically conductive layer (HB_{A}) comprises a ferromagnetic material.

6. The SOT-MRAM cell according to claim 5, wherein the additional electrically conductive layer (HB_{A}) has a sidewall (HB_{ASW}) facing the sidewall (MTJsw) of the magnetic tunnel junction (MTJ).

7. The SOT-MRAM cell according to any one of claims 4 to 6, wherein the additional electrically conductive layer (HB_{A}) is in direct contact with the electrically conductive layer (El_{A}).

8. The SOT-MRAM cell according to any one of claim 1 to 7, wherein the magnetic memory cell comprises a second electrically conductive layer (El_{B}) in direct contact with the SOT layer (SOT) via a second recess (Rec) of the dielectric layer (Ox), the electrically conductive layer (El_{A}) and the second electrically conductive layer (El_{B}) being spaced apart by the dielectric layer (Ox) .

9. The SOT-MRAM cell (700) according to claim 8, further comprising a second, additional electrically conductive layer (HB_{B}) stacked over the second electrically conductive layer (El_{B}) .

10. The SOT-MRAM cell (700) according to claim 8 or claim 9, wherein the magnetic tunnel junction (MTJ) is formed over a first and a second vias (VA, VB), the first via (VA) and the second via (VB) being electrically connected to the SOT layer (SOT) via, respectively, the electrically conductive layer (El_{A}) and the second electrically conductive layer (El_{B}).

11. The SOT-MRAM cell (700) according to any one of claim 8 to claim 10, wherein the magnetic tunnel junction (MTJ) is formed over a third via (VC) that is in direct contact with .a bottom surface of the magnetic tunnel junction (MTJ).

12. A semiconductor device (1100) comprising on a same substrate (Sub) a first region (1110) comprising memory cells according to any one of claims 1 to 9 and that are SOT-MRAM cells and a second region (1120) comprising memory cells that are STT-MRAM cells.

13. A manufacturing process of a magnetic tunnel junction for a SOT-MRAM cell according to any one of claims 1 to 11, comprising the steps of:
- patterning (S1; S1') a magnetic tunnel junction (MTJ) and a SOT layer (SOT) included therein, the SOT layer (SOT) being stacked and in direct contact with a dielectric layer (Ox) ; and
- forming (S2; S2') an electrically insulating encapsulating layer (Encaps) covering a sidewall (MTJ_{sw}) of the magnetic tunnel junction (MTJ),
the manufacturing process being **characterized in that** the magnetic tunnel junction (MTJ) and the SOT layer (SOT) are patterned with a same mask **and in that** the manufacturing process comprises the further steps of :
- exposing (S3; S3') a surface of the SOT layer (SOT) by etching a lateral portion (Oxₗₐₜ) of the dielectric layer (Ox) adjacent to the electrically insulating encapsulating layer (Encaps) and to the SOT layer (SOT) so as to form a recess (Rec) formed by a sidewall of the etched dielectric layer (Ox) being inboard from the sidewall (MTJ_{sw}) of the magnetic tunnel junction ; and
- forming (S4, S5; S4', S5') an electrically conductive layer (El_{A}) in direct contact with the SOT layer (SOT) via the recess (Rec) of the dielectric layer (Ox).

14. The manufacturing process according to claim 13, comprising the steps of providing (Start) a substrate (Sub), the patterning step (S1) comprising:
- forming successively, and in this order, the magnetic tunnel junction (MTJ), the dielectric layer (Ox) and a protecting layer (Prot) over the substrate (Sub), the SOT layer (SOT) constituting an uppermost layer of the magnetic tunnel junction (MTJ); and
- selectively etching the protecting layer (Prot), the dielectric layer (Ox) and the magnetic tunnel junction (MTJ) by using the same mask.

15. The manufacturing process according to claim 13, comprising the steps of providing (Start) a substrate (Sub) with a substrate dielectric layer (SubOx) covering a top surface thereof, the dielectric layer (Ox) forming the uppermost portion of the substrate dielectric layer (SubOx), the patterning step (S1') comprising :
- forming, on the dielectric layer (Ox), the magnetic tunnel junction (MTJ), the SOT layer constituting a lowermost layer of the magnetic tunnel junction (MTJ) ; and
- selectively etching the magnetic tunnel junction (MTJ) and the SOT layer (SOT) included therein by using the same mask.

16. The manufacturing method according to any one of claims 13 to 15, wherein the magnetic tunnel junction (MTJ) is firstly patterned longitudinally along a first direction (X) and secondly patterned longitudinally along a second direction (Y) distinct from the first direction.
